# EUROPEAN PATENT APPLICATION

(11) **EP 3 715 794 A1**
(43) Date of publication of application: **30.09.2020**
(21) Application number: 20166384.6
(22) Date of filing: 27.03.2020
(51) Int. Cl.: G01D 5/14, G01R 33/06

(54) **MAGNETIC SUBSTANCE DETECTION SENSOR**

(30) Priority: 29.03.2019 JP 2019065332; 27.09.2019 JP 2019177124
(71) Applicant: ABLIC Inc., Chiba-shi, Chiba (JP)
(72) Inventor: UEMURA, Hirotaka, Chiba-shi, Chiba (JP)
(74) Representative: Miller Sturt Kenyon

(57) **Abstract**

A magnetic substance detection sensor includes: a support substrate, a magnet having a thickness, and disposed on one of an upper main surface and a lower main surface of the support substrate so that a magnetization direction becomes parallel to the upper main surface, and a semiconductor chip disposed on one of the upper main surface and the lower main surface, and having a magnetic field detection element to detect a magnetic field component in a specific direction. The magnetic field detection element is disposed outside a first space adjacent to the magnet in the magnetization direction and having the thickness, a second space adjacent to the magnet in a direction orthogonal to the magnetization direction, and a third space extending from the first space along the direction orthogonal to the specific direction.

## Description

### BACKGROUND OF THE INVENTION

### 1. Field of the Invention

The present invention relates to a magnetic substance detection sensor.

### 2. Background Art

A magnetic substance detection sensor which detects the presence of a magnetic substance by the structure combining a magnetic field detection element and a permanent magnet has heretofore been proposed (refer to, for example, USP Nos. 8,089,276 and 9,647,144). The magnetic substance as an object of detection has a small permanent magnetization and a large permeability and may include a metal material such as steel, magnetic paint containing magnetic substance particles, and the like. The magnetic substance detection sensor is used for rotation detection of a gear, pattern detection of the magnetic paint, and the like. As compared with a general magnetic sensor detecting the proximity of the permanent magnet, the magnetic substance detection sensor is capable of easily realizing noncontact proximity detection because the object of detection is not required to be magnetized.

In USP. Nos. 8,089,276 and 9,647,144, there has been disclosed a structure in which the permanent magnet and the magnetic field detection element which is a magnetosensitive part are disposed on an approximately same plane side by side. The magnetic field detection element is constituted to detect a magnetic field component in a specific direction with respect to the magnetization direction of the permanent magnet. The specific direction is a parallel direction in USP. No. 8,089,276, and is a vertical direction in USP. No. 9,647,144. The output from the magnetic field detection element changes in proportion to the magnitude of the above-mentioned magnetic field component.

In such a structure, since the magnitude of the magnetic field component detected by the magnetic field detection element greatly changes due to a slight variation in relative position between the permanent magnet and the magnetic field detection element, an offset, which is a deviation in the output of the magnetic substance detection sensor without the magnetic substance as the object of detection, greatly fluctuates, thereby causing difficulty in detecting the magnetic substance with high accuracy.

### SUMMARY OF THE INVENTION

It is an object of the present invention to provide a magnetic substance detection sensor capable of suppressing variation in an offset due to a change in relative position between an object of detection and a magnetic substance and performing detection of the magnetic substance with high accuracy.

The present invention adopts the following structure.

A magnetic substance detection sensor according to one aspect of the present invention includes: a support substrate having an upper surface and a lower surface, a magnet having a thickness, and disposed on one of the upper main surface and the lower main surface of the support substrate so that a magnetization direction becomes parallel to the upper main surface, and a semiconductor chip disposed on one of the upper main surface and the lower main surface of the support substrate, and having a magnetic field detection element to detect a magnetic field component in a specific direction. The magnetic field detection element is disposed outside a first space, a second space and a third space: the first space is adjacent to the magnet in the magnetization direction and has the thickness, the second space is adjacent to the magnet in a direction orthogonal to the magnetization direction, and the third space extends from the first space along the direction orthogonal to the specific direction.

According to the present invention, there can be provided a magnetic substance detection sensor capable of suppressing variation in an offset due to a change in relative position between an object of detection and a magnetic substance and performing detection of the magnetic substance with high accuracy.

### BRIEF DESCRIPTION OF THE DRAWINGS

Embodiments of the invention will now be described by way of example only with reference to the accompanying drawings, in which:
FIGS. 1A and 1B are respectively a plan view and a sectional view of a magnetic substance detection sensor according to the first embodiment of the present invention;
FIG. 2 is an enlarged view of a part of the magnetic substance detection sensor of FIG. 1B;
FIG. 3 is a graph describing the operation of the magnetic substance detection sensor of the present invention;
FIGS. 4A and 4B are respectively a plan view and a sectional view of a magnetic substance detection sensor according to the second embodiment of the present invention;
FIGS. 5A and 5B are respectively a plan view and a sectional view of a magnetic substance detection sensor according to the third embodiment of the present invention;
FIGS. 6A and 6B are respectively a plan view and a sectional view of a magnetic substance detection sensor according to the fourth embodiment of the present invention;
FIGS. 7A and 7B are respectively views illustrating modifications 1 and 2 of the magnetic substance detection sensor of FIG. 6;
FIGS. 8A and 8B are respectively a plan view and a sectional view of a magnetic substance detection sensor according to the fifth embodiment of the present invention; and
FIG. 9 is a view illustrating a modification of the magnetic substance detection sensor of FIG. 8.

### DESCRIPTION OF THE EMBODIMENTS

Magnetic substance detection sensors according to embodiments to which the present invention is applied will hereinafter be described in detail with reference to the accompanying drawings. The drawings used in the following description may show the feature parts which are enlarged for convenience in order to make the features easier to understand, and the dimension ratios of the respective components or the like are not necessarily the same as the actual ones. In addition, the materials, dimensions, and the like exemplified in the following description are examples, and the present invention is not limited to them, and can be appropriately changed and implemented within the scope of the claimed invention.

### <First Embodiment>

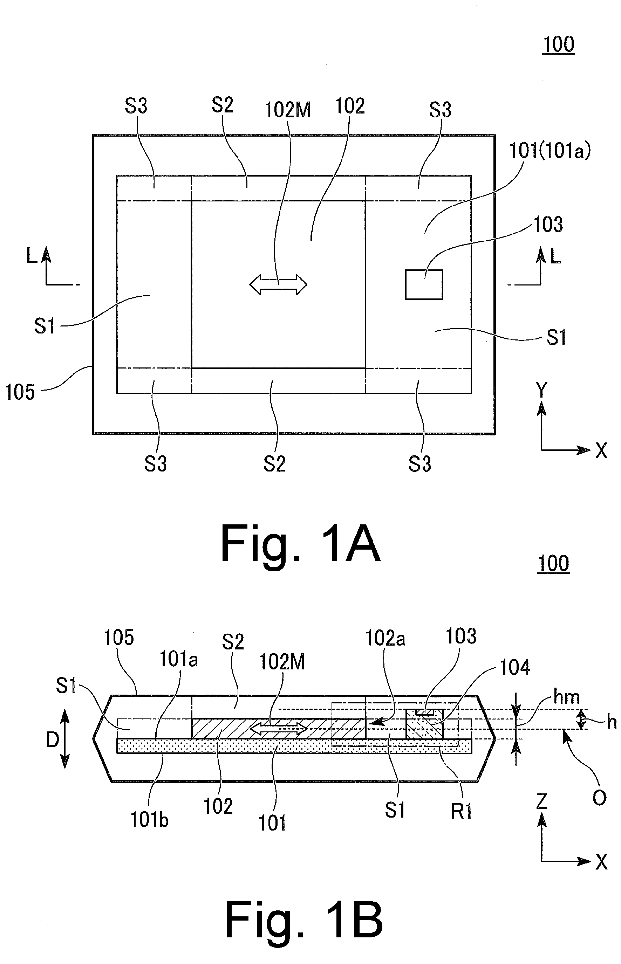

FIG. 1A is a plan view of a magnetic substance detection sensor 100 according to the first embodiment of the present invention. FIG. 1B is a sectional view of the magnetic substance detection sensor 100 of FIG. 1A which is cut by the plane passing through the line LL. The magnetic substance detection sensor 100 at least includes a support substrate 101 having an upper main surface 101a and a lower main surface 101b which are substantially flat, a magnet 102, which may also be a permanent magnet, disposed on one of the upper main surface and the lower main surface of the support substrate, from which the upper main surface locating upward is selected here, and a semiconductor chip 104 having a magnetic field detection element103, for example, a Hall element. The magnetic substance detection sensor 100 is covered and sealed with a resin film 105 or the like.

In order to indicate directions for ease of explanation in the following description, an X-axis, a Y-axis, and a Z-axis described in FIG. 1 are defined as follows: Assuming that the support substrate 100 is rectangular, the X-axis is parallel with one side of the rectangle, the Y-axis is parallel with the other side orthogonal to the one side of the rectangle, and the upper main surface is placed on an XY plane formed by the X-axis and the Y-axis. Then, the Z-axis is assumed to be the direction of a vector product of the X-axis and the Y-axis. In addition, the direction parallel to the X-axis is assumed to be an X direction, the direction parallel to the Y-axis is assumed to be a Y direction, and the direction parallel to the Z-axis is assumed to be a Z direction.

The support substrate 101 may be, for example, a lead frame, a printed substrate made of glass epoxy or the like, which is a rigid substrate, or a substrate made of a resin material, which is a flexible substrate. In the use of the flexible substrate as the support substrate 101, a reinforcing plate is preferably provided in a region in which the magnet 102 and the magnetic field detection element 103 are disposed, in order to avoid a relative position between the magnet 102 and the magnetic field detection element 103 from changing due to bending of the substrate.

The magnet 102 is disposed on the upper main surface of the support substrate 101 so that a magnetization direction 102M becomes parallel to the upper main surface. In particular, the magnetization direction 102M is ±X directions and includes not only a direction from the S pole to the N pole, but also a direction from the N pole to the S pole. In addition, the magnet 102 has a substantially rectangular parallelepiped shape and has a uniform thickness in the Z direction. Then, the center of the bottom face of the magnet 102 is an intersection point of diagonal lines between corners of the bottom face of the magnet 102, or an intersection point of median lines each obtained by connecting middle points of the opposite sides of the bottom face of the magnet 102. A plane defined by the bottom face of the magnet 102 is assumed to be an XY plane, and the origin of the XY plane is assumed to be a position where it overlaps with the center of the bottom face of the magnet 102. The Z-axis defining the Z direction extends vertically from the origin of the XY plane.

A material for the magnet 102 is not limited particularly but may include NdFeB, SmCo, or the like.

The semiconductor chip 104 is disposed on one of the upper main surface and the lower main surface of the support substrate 101 directly or with a non-magnetic member interposed therebetween. The semiconductor chip 104 in the first embodiment is disposed on the upper main surface 101a of the support substrate 101 together with the magnet 102.

The semiconductor chip 104 has a magnetic field detection element 103 having a single axis along the direction of detection, i.e., a magnetic field detection element 103 capable of detecting or sensing only a magnetic field component in a specific direction D. The specific direction D in the first embodiment is a direction orthogonal to the upper main surface 101a of the support substrate, i.e., the Z direction.

Of a space around the magnet 102, the first space S1, the second space S2, and the third space S3 are defined as follows in a space which can be formed by projecting the support substrate 101 in the Z direction and the -Z direction without enlargement nor reduction.
The first space S1: a space adjacent to the magnet 102 and having the same thickness as that of the magnet 102 in the magnetization direction 102M (±X direction),
The second space S2: a space adjacent to the magnet 102 in directions (±Y directions and ±Z directions) orthogonal to the magnetization direction 102M, and
The third space S3: a space extending from the first space S1 along the directions (±Y directions) orthogonal to the specific direction D.

Here, the first space S1, the second space S2, and the third space S3 basically have rectangular parallelepiped shapes. The second space S2 is assumed to also include a case where it extends infinitely in the Z direction or the -Z direction, and this may also apply to the other spaces S1 and S3 in certain cases.

The magnetic field detection element 103 is disposed outside the first space S1, the second space S2, and the third space S3. That is, the magnetic field detection element 103 is at a position apart from the support substrate 101, on a side of the one end 102a of the magnet in the magnetization direction 102M. The distance between the upper main surface 101a of the support substrate and the magnetic field detection element 103 is larger than the thickness of the magnet 102 in the Z direction. In view of the foregoing, the magnet 102 does not exist within a plane including the magnetic field detection element 103 and orthogonal to a detection axis of the magnetic field detection element 103, i.e., a plane parallel to the XY plane including the magnetic field detection element 103.

With the above-described configuration, approach of a magnetic substance (not illustrated) as an object of detection to the magnetic substance detection sensor 100 or separation therefrom changes the magnetic field B generated from the magnet 102. Correspondingly, a z component Bz1 of the magnetic field B detected by the magnetic field detection element 103 also changes. The amount of change ΔB in the magnetic field B becomes larger as the distance r between the magnetic substance and the magnetic substance detection sensor 100 becomes shorter. In view of this, assuming that the output of the magnetic field detection element 103 corresponding to Bz1 is V1, and the output of the magnetic field detection element 103 corresponding to a magnetic field Bz0 without magnetic substance, i.e., r=∞ is V0, the distance r can be determined with V1-V0 as an index. Here, the magnetic field Bz0 is a design value given only by the relative position between the magnet 102 and the magnetic field detection element 103. Since the magnetic field Bz0 is obtained by converting the output from the magnetic field detection element 103 without magnetic substance into the magnitude of the magnetic field, it is also called an offset magnetic field.

In the case where the magnetic field detection element 103 is a Hall element, the voltage signal proportional to the detected magnetic field Bz1 can be provided by attaching a predetermined circuit, and the distance can be determined using the provided voltage signal. Further, a circuit that determines a magnitude relation with a predetermined threshold Vt may be integrated using a general CMOS process on the same semiconductor substrate as that for the magnetic field detection element 103. The magnetic substance detection sensor can thus operate as a switch to detect that the distance r decreases smaller than a fixed value or increases larger than the fixed value.

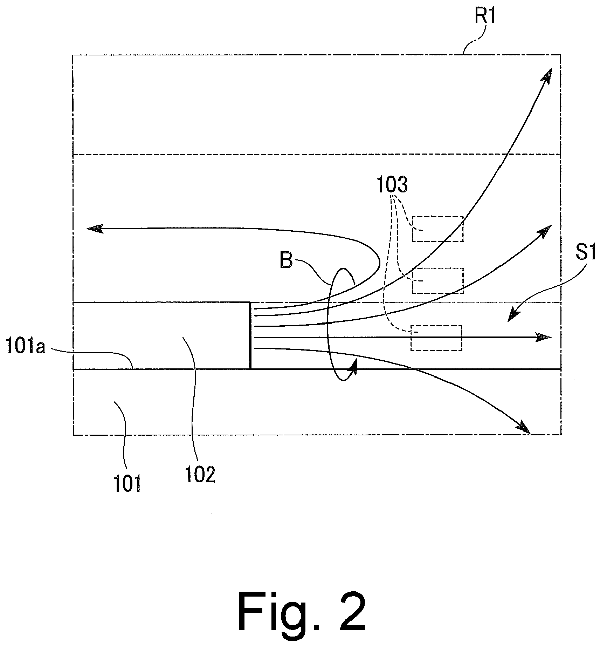

An advantageous effect of the present invention will hereinafter be described using FIG. 1B, FIG. 2, and FIG. 3. FIG. 2 is an enlarged view of a part included in a region R1 of the magnetic substance detection sensor 100 of FIG. 1B. The whole illustration of the semiconductor chip 104 is omitted herein, and only the magnetic field detection element 103 is illustrated. The magnetic field detection element 103 detects only a magnetic field component Bz in the direction orthogonal to the upper main surface 101a of the support substrate, which is the Z direction here, of a magnetic field B indicated by magnetic field lines generated and extending outside from the side of the one end 102a of the magnet 102. Accordingly, in the case where the magnetic field detection element 103 is in the first space S1, for example, the magnetic field B reaching the magnetic field detection element 103 extends approximately parallel to the upper main surface 101a of the support substrate and has almost no magnetic field component Bz, which the magnetic field detection element 103 can detect, in the vertical direction which is the Z direction.

On the other hand, in the case where the magnetic field detection element 103 is in a space, which is above the first space S1 here, more distant from the upper main surface 101a of the support substrate than the first space S1, the magnetic field B reaching the magnetic field detection element 103 extends obliquely from the upper main surface 101a of the support substrate. The magnetic field B reaching the magnetic field detection element 103 thus includes the magnetic field components Bz, which the magnetic field detection element 103 can detect, in the vertical direction which is the Z direction.

In the case where the magnetic field detection element 103 is in a space far more distant from the upper main surface 101a than the first space S1, the magnetic field B reaching the magnetic field detection element 103 has the magnetic field component Bz in the vertical direction, i.e., Z direction. The position where the magnetic field component Bz penetrating the magnetic field detection element 103 in the vertical direction (Z direction) becomes large differs depending on the magnitude of magnetization of the magnet 102 and its shape.

Accordingly, the magnetic field Bz0 changes according to the positional relation between the magnet 102 and the magnetic field detection element 103. More specifically, assuming that a plane which passes through a point where the thickness of the magnet 102 becomes 1/2 (half) and is parallel to the XY plane, is a central surface O in the direction (Z direction) apart from the upper main surface 101a of the support substrate 101, the offset magnetic field Bz0 changes depending on the distance h between the central surface O and the magnetic field detection element 103. Variation of the distance h, for example, due to manufacturing deviation of the magnet 102, variation in the thickness of the semiconductor chip 104 due to the backgrinding process, and the like hence varies the offset magnetic field Bz0 around the design value, and the estimation accuracy of the distance r to the object (magnetic substance) of detection which is estimated from the measured magnetic field Bz1 degrades. Consequently, there is a need to reduce the variation σBz0 in the offset magnetic field Bz0 relative to the variation σh in the distance h or reduce the differential coefficient (dBzO/dh) relative to the distance h, of the offset magnetic field Bz0 for realizing a high-accurate magnetic substance detection sensor.

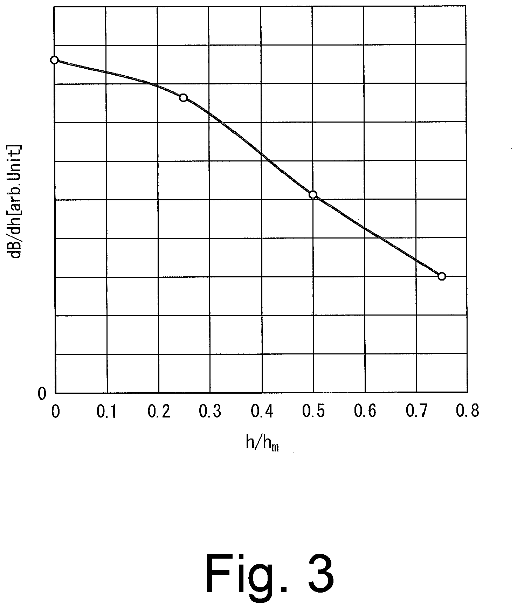

FIG. 3 is a graph illustrating a result of simulating (dBzO/dh) with respect to h/hm. Since hm is the thickness of the magnet 102, the horizontal axis of FIG. 3 indicates a value obtained by standardizing h with the thickness of the magnet 102. An equation h/hm=0 indicates a case where the magnetic field detection element 103 is placed on the central surface O of the magnet. An inequality -0.5<h/hm<0.5 corresponds to the first space, and inequalities h/hm>0.5 and h/hm<-0.5 correspond to the outside of the first space. In the simulation, a magnetic field simulation based on a two-dimensional finite element method is used. A description will be made as to conditions for the simulation by referring FIG. 1B. The magnet 102 is assumed to be made of NdFeB, the thickness thereof in the Z direction is assumed to be 1.0mm, and the length thereof in the X direction is assumed to be 3.0mm. The distance in the X direction between the magnetic field detection element 103 and the one end 102a of the magnet is assumed to be 0.5mm.

It is understood from this graph that h/hm=0 indicates a state in which the magnetic field detection element 103 is in the first space S1, and (dBzO/dh) takes the maximum. In addition, (dBzO/dh) can be reduced more than 40% by taking h/hm>0.5, i.e., disposing the magnetic field detection element 103 in the space adjacent to the first space S1 in the Z direction. That is, the variation in the magnetic field B due to σh can be greatly reduced by taking h>0.5hm.

Incidentally, the magnetic field detection element 103 is preferably disposed directly above the first space S1 so as to overlap with the first space S1 in a plan view from the specific direction D. Since the magnetic flux in the Z direction which is generated from the magnet 102 is distributed with a high density in a region just above the first space S1, the magnetic field detected by the magnetic field detection element 103 can be made large by disposing the magnetic field detection element 103 in the region. As a result, the change V1-V0 in the signal caused by the approach of the magnetic substance (not illustrated) of detection also becomes large, thereby making it possible to enhance the sensitivity of the magnetic substance detection sensor 100.

As described above, in the magnetic substance detection sensor 100 of the first embodiment, the semiconductor chip 104 is disposed to suppress the variation in the magnetic field Bz0 detected by the magnetic field detection element 103 to be small. For that reason, according to the magnetic substance detection sensor 100 of the first embodiment, it is possible to suppress the variation in the sensitivity due the change in the relative position to the magnetic substance as the object of detection, and perform detection of the magnetic substance with high accuracy.

### <Second Embodiment>

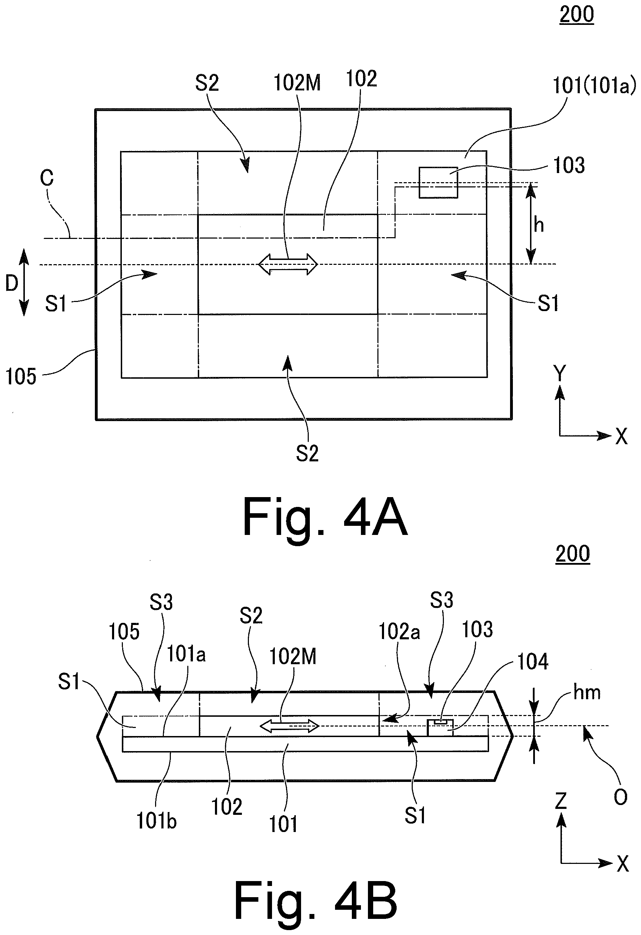

FIG. 4A is a plan view of a magnetic substance detection sensor 200 according to the second embodiment of the present invention. FIG. 4B is a sectional view of the magnetic substance detection sensor 200 of FIG. 4A which is cut along the polyline C.

In the magnetic substance detection sensor 200, a magnetic field detection element 103 is disposed in a space adjacent to the first space S1 in the Y direction. A distance between the upper main surface 101a of a support substrate 101 and the magnetic field detection element 103 is preferably less than or equal to the thickness of the magnet 102 in the Z direction. A specific direction D in the second embodiment is assumed to be the direction (Y direction) parallel to the upper main surface 101a of the support substrate 101 and orthogonal to the magnetization direction 102M of the magnet 102. The third space S3 in this case becomes a space adjacent to the first space S1 in the Z direction but not in the Y direction. Configurations other than the above are similar to those in the magnetic substance detection sensor 100 of the first embodiment, and their corresponding elements are denoted by the same reference numerals without depending on differences in shape.

The magnetic field detection element 103 of the second embodiment detects only a magnetic field component By in the Y direction, of a magnetic field B, which is indicated by magnetic field lines, generated and extending outwardly from the side of the one end 102a of the magnet. Accordingly, in the case where the magnetic field detection element 103 is in the first space S1, the magnetic field B reaching the magnetic field detection element 103 exists along the X direction substantially parallel to the magnetization direction 102M, and has almost no magnetic field component By, which the magnetic field detection element 103 can detect, in the vertical direction which is the Y direction.

On the other hand, in the case where the magnetic field detection element 103 is placed outside the first space S1 in the Y direction, the magnetic field B reaching the magnetic field detection element 103 extends obliquely with respect to the magnetization direction 102M of the magnet 102. The magnetic field B reaching the magnetic field detection element 103 has thus the magnetic field component By, which the magnetic field detection element 103 can detect, in the Y direction.

Even outside the first space S1, the intensity of the magnetic field component By in the Y direction differs depending on the position, and the position where the magnetic field component By, which penetrates the magnetic field detection element 103 in the Y direction, becomes large differs even depending on the magnitude and shape of magnetization of the magnet 102.

The offset magnetic field By0 in the second embodiment also changes depending on the positional relation between the magnet 102 and the magnetic field detection element 103. That is, assuming that a plane which passes through a point where the width of the magnet 102 being its length in the Y direction becomes 1/2 (half) and which is parallel to a ZX plane, is a central surface O in the direction (Y direction) orthogonal to the magnetization direction 102M along the upper main surface 101a of the support substrate 101, the offset magnetic field By0 changes depending on the distance h between the central surface O and the magnetic field detection element 103.

The magnetic substance detection sensor 100 of the first embodiment is constituted to suppress the differential coefficient (dBzO/dh) of the offset magnetic field Bz0 with respect to the distance h to be small by keeping the magnetic field detection element 103 away from the first space S1 along the Z direction. On the other hand, the magnetic substance detection sensor 200 of the second embodiment is constituted to suppress the differential coefficient (dBy0/dh) of the offset field By0 with respect to the distance h to be small by keeping the magnetic field detection element 103 away from the first space S1 along the Y direction. Accordingly, as with the first embodiment even in the case of the second embodiment, the direction to keep the magnetic field detection element 103 away is changed from the Z direction to the Y direction, thereby making it possible to suppress variation in the sensitivity due to a change in relative position with the magnetic substance as an object of detection, and perform detection of the magnetic substance with high accuracy.

### <Third Embodiment>

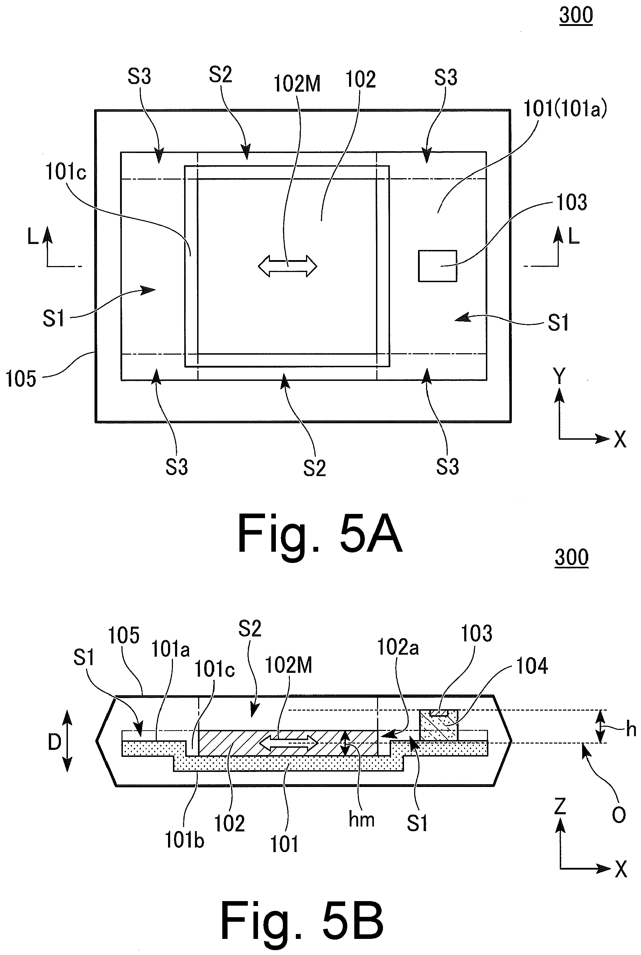

FIG. 5A is a plan view of a magnetic substance detection sensor 300 according to the third embodiment of the present invention. FIG. 5B is a sectional view of the magnetic substance detection sensor 300 of FIG. 5A which is cut by the plane passing through line LL.

In the magnetic substance detection sensor 300, a lead frame is used as a support substrate 101, and a recess 101c is provided on one of the upper main surface and the lower main surface of the support substrate 101, from which the upper main surface 101a is selected here. A portion overlapping with the recess 101c serves as a protrusion on the lower main surface 101b of the support substrate 101. A magnet 102 is disposed within the recess 101c so that a magnetization direction 102M becomes substantially parallel to the upper main surface 101a of the support substrate 101. Constituents other than the above are similar to those in the magnetic substance detection sensor 100 of the first embodiment, and their corresponding elements are denoted by the same reference numerals without depending on differences in shape.

In the use of the flat support substrate 101 as in the first and second embodiments, increasing the thickness of the magnet 102 encounters difficulty in disposing the magnetic field detection element 103 apart from the first space S1. In the third embodiment, however, a part or all of the magnet 102 in the thickness direction (Z direction) is stored in the recess 101c, and correspondingly, the influence of the increase in the thickness of the magnet 102 can be reduced or eliminated. The magnetic substance detection sensor 300 of the third embodiment has hence no obstacle in increasing the thickness of the magnet 102. Increasing the thickness of the magnet 102 enables increase of both the magnetic fields Bz0 and Bz1 detected by the magnetic field detection element 103. As a result, the magnetic substance detection sensor 300 having high sensitivity can be obtained.

Further, a central surface O of the magnet 102 in the Z direction is shifted in a depth direction of the support substrate 101 to thereby increase a distance h from the central surface O of the magnet 102 to the magnetic field detection element 103. Correspondingly, of the magnetic field B generated from the magnet 102, the magnetic field B reaching the magnetic field detection element 103 has a large oblique angle relative to the upper main surface 101a of the support substrate 101, and has a large magnetic field component Bz in the Z direction. Accordingly, the magnetic substance detection sensor 300 of the third embodiment can obtain a higher sensitivity than that of the magnetic substance detection sensor 100 of the first embodiment by the increase of the magnetic field component Bz reaching the magnetic field detection element 103 when the distance between the upper main surface 101a of the support substrate and the magnetic field detection element 103 is fixed.

In the magnetic substance detection sensor 300 of the third embodiment, the magnetic field detection element 103 detects the amount of change in the magnetic field component (Bz1-Bz0) caused by the approach of an unillustrated object of detection from the positive direction of the Z-axis illustrated in FIGS. 5A and 5B. The amount of change in the magnetic field component (Bz1-Bz0) detected by the magnetic field detection element 103 can be made large by satisfying the following two conditions (1) and (2):
(1) The thickness of the magnet 102 in the Z-axis direction is large, and
(2) The magnetic field detection element 103 is located on the upper side in the Z-axis direction, which is a side separated from the support substrate 101, of the central surface O in the Z-axis direction of the magnet 102.

That is, in the magnetic substance detection sensor 300 of the third embodiment, the thickness in the Z-axis direction of the magnet 102 can be made thick, and the conditions of (1) and (2) can simultaneously be optimized by the depth of the recess 101c. As a result, the sensitivity of the magnetic substance detection sensor 300 is enhanced.

### <Fourth Embodiment>

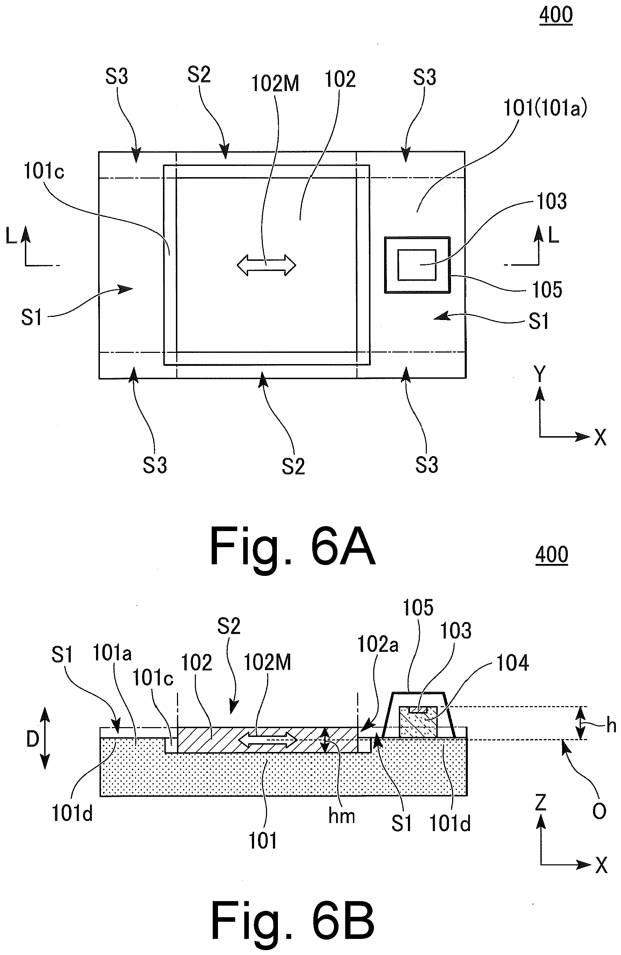

FIG. 6A is a plan view of a magnetic substance detection sensor 400 according to a fourth embodiment of the present invention. FIG. 6B is a sectional view of the magnetic substance detection sensor 400 of FIG. 6A which is cut by the plane passing through the line LL.

In the magnetic substance detection sensor 400, a rigid substrate, a flexible substrate or the like is used as a support substrate 101. A recess 101c is provided on the upper main surface 101a of the support substrate 101. A magnet 102 is disposed within the recess 101c. A magnetic field detection element 103 is disposed outside the recess 101c. A resin film 105 covers the magnetic field detection element 103. Constituents other than the above are similar to those in the magnetic substance detection sensor 100 of the first embodiment, and their corresponding elements are denoted by the same reference numerals without depending on differences in shape.

In the magnetic substance detection sensor 400, unlike the magnetic substance defection sensor 100 of the first embodiment, since the magnet 102 is not covered with the resin film 105, the stress applied to the support substrate 101 by the resin film 105 can be reduced. As a result, deviation in characteristics of the magnetic field detection element 103 accompanying this stress can be suppressed to be small.

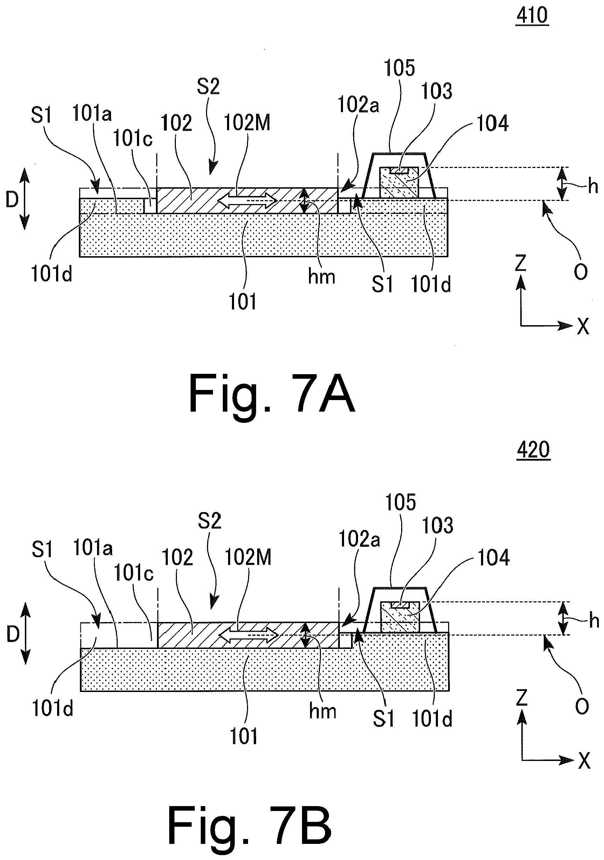

FIGS. 7A and 7B are respectively sectional views of magnetic substance detection sensors 410 and 420 according to modifications 1 and 2 of the fourth embodiment. In the support substrate 101 of the magnetic substance detection sensor 400 of FIG. 6B, portions 101d constituting the sidewalls of the recess 101c are integral with other portions such as flat portions including the bottom wall, but the portions 101d may be formed as bodies separate from the other portions as in the magnetic substance detection sensor 410 of FIG. 7A. In the case where the portions 101d are formed as the separate bodies, the magnetic field detection element 103 is disposed above the support substrate 101 with an intervention of an intermediate member (for example, 101d) constituting the sidewall of the recess 101c.

Further, in the magnetic substance detection sensor 400 of FIG. 6B, the recess 101c is formed in the center, which is a region inside of the ends, of the upper main surface 101a of the support substrate, but as in the magnetic substance detection sensor 420 of FIG. 7B, the recess 101c may extend to the end of the upper main surface 101a. Even in this case, a portion 101d constituting the sidewall of the recess 101c may be integral with other portions or may be a separate body.

### <Fifth Embodiment>

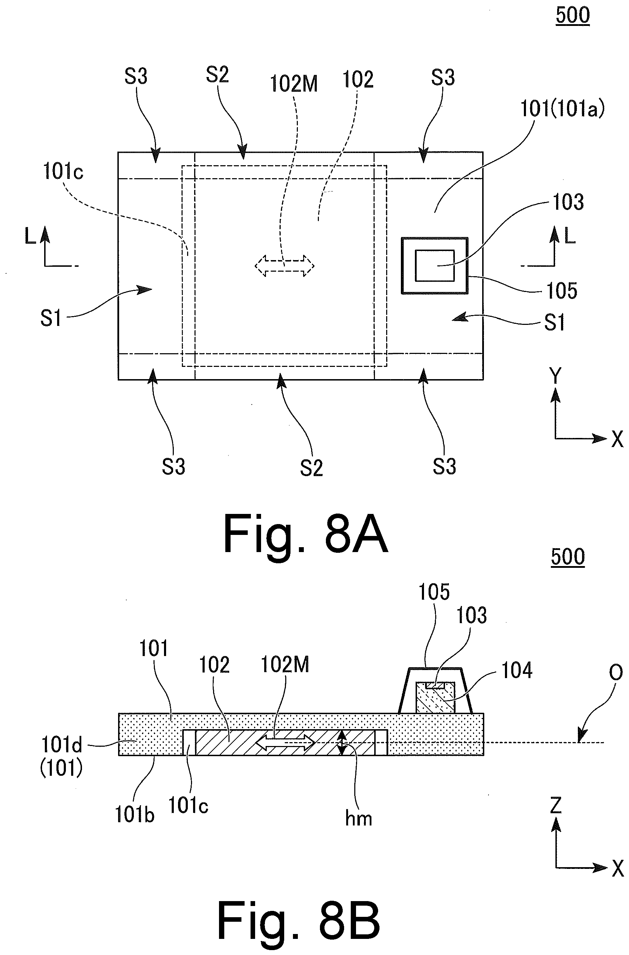

FIG. 8A is a plan view of a magnetic substance detection sensor 500 according to a fifth embodiment of the present invention. FIG. 8B is a sectional view of the magnetic substance detection sensor 500 of FIG. 8A which is cut by the plane passing through the line LL.

In the magnetic substance detection sensor 500, a magnet 102 is formed on the lower main surface 101b of a support substrate 101. That is, the magnet 102 is disposed on the opposite side to a magnetic field detection element 103 with the intervention of the support substrate 101 therebetween. Constituents other than the above are similar to those in the magnetic substance detection sensor 100 of the first embodiment, and their corresponding elements are denoted by the same reference numerals without depending on differences in shape.

The support substrate 101 may be flat and the magnet 102 may be disposed on the lower main surface 101b, but a recess 101c may also be formed in the lower main surface 101b of the support substrate 101, and the magnet 102 may be disposed within the recess 101c, as illustrated in FIG. 8B. The placement of the magnet 102 within the recess 101c is preferable because the thickness in the Z direction of the magnetic substance detection sensor 500 can be reduced.

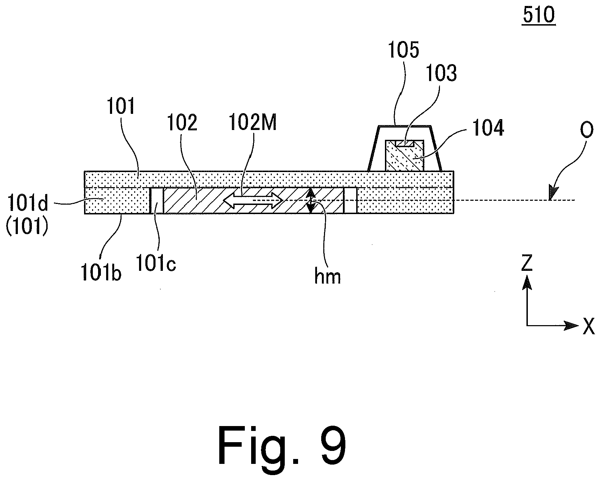

FIG. 9 is a sectional view of a magnetic substance detection sensor 510 according to a modification of the fifth embodiment. The sidewall portion 101d of the recess may be a separate body although the sidewall portion 101d is integral with other portions such as flat portions including the bottom wall in the magnetic substance detection sensor 500 of FIG. 8B.

## Claims

1. A magnetic substance detection sensor (100), comprising:
a support substrate (101) having an upper main surface (101a) and a lower main surface (101b);
a magnet (102) having a thickness (hm), and disposed on one of the upper main surface and the lower main surface of the support substrate so that a magnetization direction (102M) becomes parallel to the upper main surface; and
a semiconductor chip (104) disposed on one of the upper main surface and the lower main surface of the support substrate, and having a magnetic field detection element (103) configured to detect a magnetic field component in a specific direction,
wherein the magnetic field detection element is disposed outside a first space (S1), a second space (S2) and a third space (S3): the first space is adjacent to the magnet in the magnetization direction and has the same thickness as the magnet, the second space is adjacent to the magnet in a direction (Y) orthogonal to the magnetization direction, and the third space extends from the first space along the direction orthogonal to the specific direction.

2. The magnetic substance detection sensor according to claim 1, wherein the semiconductor chip is disposed on the upper main surface (101a) of the support substrate, and
wherein a distance between the upper main surface (101a) of the support substrate and the magnetic field detection element is larger than the thickness of the magnet (hm) in the direction orthogonal to the magnetization direction.

3. The magnetic substance detection sensor according to claim 1 or claim 2, wherein the magnet is disposed in a recess (101c) provided on one of the upper main surface (101a) and the lower main surface (101b) of the support substrate.

4. The magnetic substance detection sensor according to claim 1, wherein the semiconductor chip is disposed relative to one of the upper main surface and the lower main surface of the support substrate with an intervention of an intermediate member (101d) therebetween.

5. The magnetic substance detection sensor according to claim 1, wherein the magnetic field detection element overlaps with the first space in a plan view from the specific direction.

6. The magnetic substance detection sensor according to claim 1, wherein the magnetic field detection element is covered with a resin film (105).
